# EUROPEAN PATENT SPECIFICATION

(11) **EP 1 603 205 B1**
(45) Date of publication and mention of the grant of the patent: **26.12.2007**
(21) Application number: 04102805.1
(22) Date of filing: 18.06.2004
(51) Int. Cl.: H01S 5/042, H01S 5/068

(54) **System and method for controlling optical sources, such as laser diodes, and computer program product therefor**
System und Verfahren zur Kontrolle von optischen Quellen, zum Beispiel Laserdioden, und zugehöriges Computerprogramm
Système et méthode pour contrôler des sources optiques, telles que des diodes laser, et programme informatique associé

(30) Priority: 04.06.2004 GB 4125092
(43) Date of publication of application: 07.12.2005
(73) Proprietor: Avago Technologies Fiber IP (Singapore) Pte. Ltd., Singapore 768923 (SG)
(72) Inventor: Everett, Keith, Ipswich, Suffolk IP1 5PB (GB); Hook, Clive John, Ipswich, Suffolk IP1 5PB (GB); Stafford, Neil, Ipswich, Suffolk IP1 5PB (GB); Hitchin, Luke, Agilent Techn. Singapore Pte Ltd., Mukin 19, Singapore 768923 (SG)
(74) Representative: Jehan, Robert

(56) References cited:
- EP-A- 0 793 316
- EP-A- 1 233 488
- US-A- 5 018 154

## Description

Commercial applications of optical sources such as e.g. laser diodes for WDM (Wavelength Division Multiplex) require real time automatic control of a number of operating parameters such as e.g. the wavelength emitted, the optical power and the extinction ratio (ER), that is the ratio between the optical power of a "1" and the optical power of a "0" emitted by the optical source controlled.

The control system(s) must be compact in size in order to be co-packaged with the other components (typically the optical radiation source and the modules currently associated therewith) while avoiding coupling, space and power dissipation problems.

A number of different techniques have been proposed in the art for wavelength and power control of optical sources. These include both analog arrangements, as disclosed e.g. in US-A-5 825 792, and micro-controller based systems for controlling a laser driver in a transceiver (see e.g. US-A-5 019 769). Fairly sophisticated wavelength control apparatus is also known e.g. from US-A-5 438 579 intended to counter temperature variations as the main source of undesired wavelength variations.

EP 1 233 488 discloses a laser driver in which bias and modulation currents are controlled according to sensed temperature and output power respectively.

Wavelength (and power) control of an optical source such as a laser diode is frequently performed by means of a "wavelength locker" arrangement. A current wavelength locker arrangement includes a wavelength selective optical component and photodiodes to detect any wavelength and power variations in the laser source, a laser driver to bias the laser diode and a thermoelectric element such as a Peltier element for controlling the temperature of the laser diode together with its drive circuit.

The extinction ratio may be controlled by controlling the modulation current required to produce the correct extinction ratio by using a model of the modulation current against the bias current. This approach is adapted to be implemented by means of dedicated integrated circuits (ICs) using the same algorithm but differing in the way the set up is accomplished.

This arrangement may turn out to be unsatisfactory for fast, modern lasers sources. In fact, this approach assumes that the optical power is held constant at all temperatures. With some recent "fast" laser sources an improvement in the eye quality can be obtained by changing the optical power output at different temperatures. This in turn can cause problems in controlling the extinction ratio (ER).

Additionally, a key factor to be taken into account in producing such control systems is flexibility, that is the possibility of adapting the same system to controlling devices with different characteristics (working point, bias current and temperature, requirements in terms of stability, frequency and power, driver response).

The need is thus felt for control systems adapted to be associated with an optical source in a compact arrangement while satisfying a number of basic requirements such as:
- the control system must be flexible and cheap,
- all the components must be suitable to be mounted on board while admitting only pre-operational initialisation using external apparatus,
- board space and component count must be reduced, in order to reduce production cost, and
- the system must enable control of the optical source to provide different optical powers at different temperatures.

The object of the present invention is to provide an improved control arrangement fully satisfying the requirements outlined in the foregoing.

According to the present invention, such an object is achieved by means of a system having the features called for in the claims that follow. The invention also relates to a corresponding method and a computer program product, loadable into the memory of a computer (e.g. a digital controller/processor such as e.g. a so-called programmable system on a chip or "psoc") and comprising software code portions for implementing the system of the invention and/or performing the steps of the method of the invention when that product is run on the controller. As used herein, reference to such a computer program product is intended to be equivalent to reference to a computer-readable medium containing instructions for controlling a computer system to coordinate the performance of the system/method of the invention.

A preferred embodiment of the invention includes programmable driver device implemented on a commercially available device such as a so-called programmable system on a chip or "psoc". This has a microprocessor core and configurable hardware blocks that can perform analog and digital functions. Being programmable, this allows the control algorithm/function to be changed without changing the surrounding hardware/pcb (printed circuit board) layout.

In a particularly preferred embodiment, the threshold current of the source is modelled against temperature at set up. During operation, the temperature of the laser is measured and the threshold current is obtained from the model. The bias current required to produce the optical power is measured and the difference between the bias current the threshold current calculated. This gives a measure of the slope efficiency of the laser at the operating temperature. By multiplying the bias current - threshold current difference by a constant (according to the extinction ratio required) the required modulation current is obtained.

The system is preferably designed to allow changes in the optical power, particularly with temperature and is best implemented using a microprocessor. The optical power loop would be implemented using standard analog components with the optical power set point being provided by the microprocessor. The bias current and temperature would then be fed into the processor, which would calculate the required modulation current,

The invention will now be described, by way of example only, with reference to the enclosed figures of drawing, wherein:
- Figure 1 is a block diagram showing the general layout of a system according to the invention, and
- Figure 2 is a flowchart representative of possible exemplary operation of the system of figure 1.

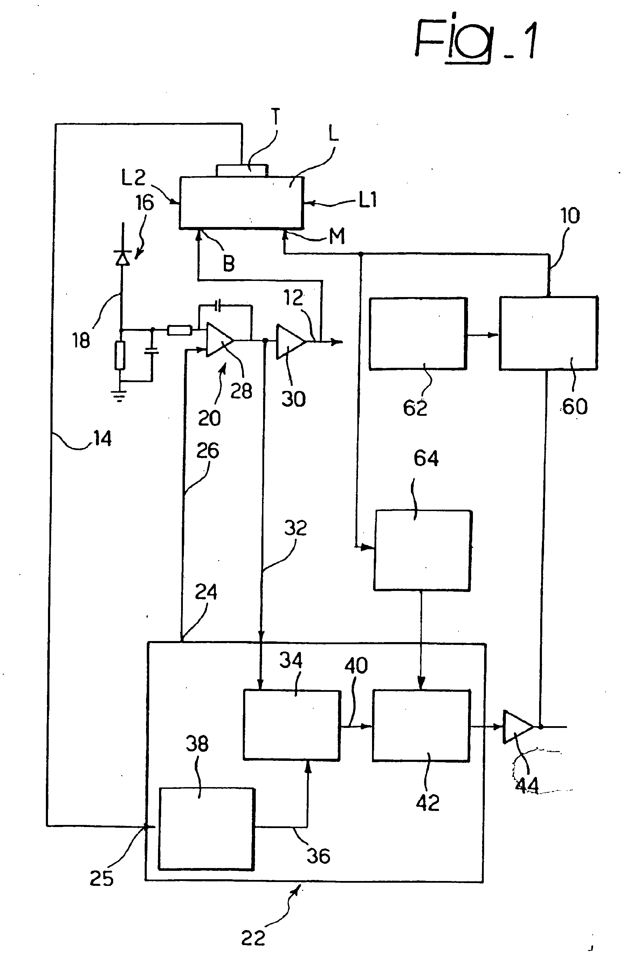

In Figure 1, reference L denotes an optical source such as a laser diode adapted for use e.g. in a WDM (Wavelength Division Multiplex) fiber-optic transmission system, for instance of the "dense" type (D-WDM) .

The laser source L includes a front facet L1 from which the "useful" radiation beam to be injected into a fiber (not shown) is generated. The laser source L also includes a back facet L2 from which optical radiation is derived for control purposes as better detailed in the following.

Operation of the laser source is controlled via two input ports B and M for the bias current and the modulation current, respectively.

All of the foregoing corresponds to a device arrangement and criteria of operation that are well known in the art, thus making it unnecessary to provide a further detailed description herein.

This applies i.a. to the basic principle of generating the high speed, high current modulation current applied to the laser L by combining two components, namely:
- a low current, very low frequency signal representing the required modulation current, and
- a high speed, low current data signal.

Similarly known is the possibility of associating with the laser source L a temperature sensor T.

Associated with the laser are additional components such as e.g. a thermoelectric element (such as a Peltier element) adapted to control the temperature of the laser junction in order to stabilize or "lock" the emission wavelengths thereof. Emission wavelength "locking" is usually accomplished by detecting the actual emission wavelengths of the laser L, which preferably occurs based on radiation derived from the back facet L2 of the laser. These and other ancillary components typically associated with the laser source L are not shown and will not be described herein as these ancillary components are of no direct momentum for the exemplary arrangement of the invention considered herein.

The arrangement described in detail herein is intended to control the extinction ratio (ER) that is the ratio between the optical power of a "1" and the optical power of a "0" emitted by the laser L via the front facet L1.

More specifically, the control action involves controlling the modulation current as provided over a line 10 to the input port M of the laser while also controlling the bias current provided over a line 12 to the input port B.

Reference numeral 14 designates a line coming down to the temperature sensor T associated with the laser source L and conveying a signal indicative of the temperature of the laser (junction).

Reference 16 designates a photodiode (or an analogous opto-electrical converter) exposed to the radiation (light) from the back facet L2 of the laser L. The photodiode 16 provides over a line 18 a signal indicative of the intensity of the radiation from the back facet of the laser to an analogue bias control circuit designated as a whole by reference numeral 20.

Reference numeral 22 designates as a whole a controller device of the type commercially available under the designation of programmable system on a chip (psoc). This device currently includes a microprocessor core and configurable hardware blocks that can perform analogue and digital functions. Being programmable, such a device is adapted to implement a control algorithm that can be changed without changing the surrounding hardware PCB (Printed Circuit Board) layout.

The device 22 operates as a driver and includes a first output port 24 adapted to provide over a line 26 a signal representative of a desired optical power set point for the source L.

The signal provided over the line 26 is fed to one of the inputs (typically the non-inverting input) of a differential amplifier 28 included in the analog circuit 20.

The other input (typically, the inverting input) of the amplifier 28 is fed with a signal derived (via standard filtering and scaling circuitry) from the line 18 and thus from the photodetector 16.

The output signal from the differential amplifier/stage 28 is fed to a voltage-to-current converter 30 whose output is the bias current signal fed to the bias input port B of the laser L via the line 12.

The arrangement comprised of the photodiode 16 and the circuit 20 implements an analogue feedback loop intended to control the bias current to the laser L at a level adapted to ensure that the optical power from the front facet L1 corresponds to the set point value provided by the driver device 22 over the line 26.

A signal indicative of the bias current input at the bias port B is derived from the circuit 20 over a line 32 that extends towards the driver device 22.

In the exemplary embodiment described herein, the bias current signal on the line 32 is derived from the output of the differential amplifier 28.

Those of skill in the art will promptly appreciate that the specific arrangement shown is a purely exemplary one: a signal representative of the bias current applied to the laser L may in fact be derived at other points of the circuit 20, for instance at the output of the voltage-to-current (transconductance) converter/amplifier 30.

Deriving ("tapping") the signal on the line 32 at the output of the amplifier 30 is however an advantageous choice as the voltage signal derived thereby is directly adapted for comparison in a comparator block 34 included in the drive device 22.

In the comparator 34 the signal on the line 32, which is representative of the laser bias current, is compared with a signal present on a line 36 and generated by a block 38.

Essentially, the block 38 has the purpose of modelling a threshold current against temperature at set up of the arrangement shown. During operation, the temperature of the laser L is measured (via the sensor T) and a corresponding "model" threshold current value is obtained in the block 38.

Essentially, in the block 38 the laser temperature as sensed by the sensor T and represented by the signal input to the drive device 22 via the input port 25 is used to generate a value representative of a threshold current. In a currently preferred embodiment, modelling involves using a third order polynomial, where only the coefficients are stored. The threshold current is calculated for each measured temperature. The coefficients are derived by plotting the measured threshold current against temperature and searching for the best-fit condition.

The signal on the line 32 is representative of the bias current required to produce a desired value of the optical power.

The signal emitted by the comparator 34 over an output line 40 is thus a signal representative of the difference between the bias current (line 32) and the threshold current calculated (as a function of temperature) in the block 38. Essentially, the difference signal output from the comparator 34 (line 40) gives a measure of the "slope efficiency" of the laser at the operating temperature.

The signal on the line 40 is multiplied by a constant in a multiplier block or module 42 (i.e. a gain factor) included in the driver device 22 to produce, via another voltage-to-current (transconductance) converter/amplifier 44, a current signal adapted to drive the modulation current fed to the laser input port M over the line 10.

The multiplier block or module 42 is programmable in that the value of the multiplier constant can be selectively varied.

As schematically shown in figure 1, the output stage of the amplifier 44 has an associated high speed switch in the form of an integrated circuit (IC) located local to the laser source L.

The switch in question either switches the modulation current towards the laser L (line 10, input M, via a driver unit 60 to be better described in the following), hence increasing the laser optical output, or switches it into a dummy load (not shown), giving a lower optical output, thus controlling, in a manner known per se, the extinction ratio (ER).

As indicated in the foregoing, the high speed, high current modulation current applied to the laser L via the modulation port M is comprised of two components, namely a low current, very low frequency signal representing the required modulation current and a high speed, low current data signal.

More in detail, the signal produced by the output of the psoc driver device 22 is a low current, very low frequency (near dc) signal representing the required modulation current. The signal from the driver device 22 is fed into the laser driver circuit 60, which is typically in the form of an integrated circuit or IC. The laser driver 60 takes this signal and combines it with the high speed, low current modulation data produced by a modulation source 62 (of a known type) to produce the actual high speed, high current modulation current used to drive the laser L.

There is a current gain between the actual modulation current and the signal produced by the output of the psoc driver device 22, and this current gain is exposed to undesired variations in that it may vary over temperature.

To overcome this problem, in the arrangement disclosed herein the actual modulation current applied to the laser source L is sensed (measured) using an RF power monitor (again typically in the form of an integrated circuit or IC) 64.

The power monitor 64 provides a near dc voltage signal that is proportional to the high frequency modulation current. This is fed back to the driver device 22 (e.g. towards the multiplier/gain block 42, alternative choices being however evident for those of skill in the art) so that the signal produced by the output of the psoc driver device 22 can be adjusted accordingly. This arrangement is essentially in the form of a modulation current feedback to the driver device 22 so that the output of the driver device 22 is adjusted to give the correct modulation current.

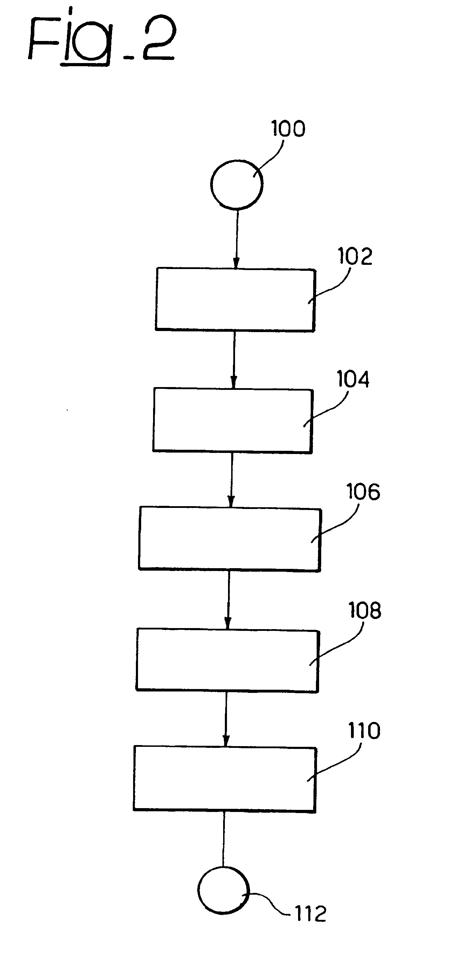

The flow chart of figure 2 is exemplary of the basic processing operation performed within the arrangement just described. This operation essentially is co-ordinated by control logic/software code included (in a manner known per se) in the driver device 22.

Typically, the set of operations or steps represented by the flowchart of figure 2 may be repeated between 50 to 100 times per second during operation of the laser L.

After a start step 100, in a step 102 the temperature of the laser L, as represented by the signal present on the line 14 (input 25 to the driver device 22) is measured.

In a step 104, a corresponding value for the threshold current is obtained from the module represented by the block 38.

In a step 106, the bias current value received over the line 32 is measured and in a step 108 the bias current in question and the threshold current value produced by the block 38 are compared to produce the output signal from the comparator 34.

The step 110 represents the multiplication of the output signal from the comparator 34 by a constant in view of transmission to the transconductance amplifier 42.

The end of the sequence of operation described is marked by an end step designated 112.

Those of skill in the art will appreciate that, despite the strictly sequential nature of the flowchart of Figure 2, at least some of the operations/steps described therein may be performed in parallel.

The driver device 22 is preferably in the form of a programmable system on a chip (psoc), including a microprocessor core and configurable hardware blocks, thus making the device 22 capable of performing both analogue and digital functions. Being programmable, the control principles implemented thereby (for instance the model implemented in the block 38 or the multiplying constant of the block 42) can be changed without having to change the surrounding hardware and PCB layout.

Of course, the principles of the invention remaining the same, the details of construction and the embodiments may widely vary with respect to what has been described and illustrated purely by way of example, without departing from the scope of the present invention as defined by the annexed claims.

This applies i.a. to a number of variants, including but not limited to:
- adopting as the controller (i.e. the driver device 22) a type of controller different from a psoc: possible alternatives include but are not limited to e.g. a microprocessor, a micro-controller, a microcomputer or a processing module/function of a digital processing device that supervises operation of the whole arrangement of parts shown in figure 1;
- different implementations of the bias control circuit 20; for instance, while described herein as a separate analog circuit, the circuit 20 can be implemented partly in psoc form and partly in hardware, thus integrating it at least partly with the driver device 22.

Additionally, it will be appreciated that terms such as "optical", "light", "photosensitive", and the like are used herein with the meaning currently allotted to those terms in fiber and integrated optics, being thus intended to apply to radiation including, in addition to visible light, e.g. also infrared and ultraviolet radiation.

## Claims

1. A system suitable for controlling operation of an optical source (L) by controlling a bias current (B) and a modulation current (M) supplied (12, 10) thereto, the source having associated sensors (16, T) for sensing the radiation generated by said optical source (L) and the temperature of said optical source (L) to derive a first signal (18) indicative of the power of said radiation and a second signal (14) indicative of said temperature, the system including:
- a control circuit (20) for controlling said bias current (B) as a function of the difference between said first signal (18) indicative of the power of said radiation and a predetermined optical power set point signal (26), while generating a signal (32) indicative of said bias current, and
- a driver device (22) including:
- an output (24) for producing said predetermined optical power set point signal (26),
**characterised in that** the driver device further includes:
- a modelling block (38) for generating a current threshold value (36) as a function of said second signal (14) indicative of said temperature sensed (T), and
- a comparator (34) fed with said signal (32) indicative of said bias current and said threshold current value (36) to produce the difference thereof; said comparator (34) having associated at least one gain factor (42, 60) to produce at least one component of said modulation current (10) as a function (42) of said difference (40).

2. The system of claim 1, **characterised in that** said optical source (L) is a semiconductor laser source.

3. The system of claim 1, **characterised in that** it includes an analog circuit (20) to produce said bias current (12) as a function of said first signal (18) indicative of the power of said radiation and said predetermined optical power set point signal (26).

4. The system of claim 3, **characterised in that** it includes a voltage-to-current converter (30) for generating said bias current (12) as a function of said first signal (18) indicative of the power of said radiation and said predetermined optical power set point signal (26).

5. The system of any of the previous claims, **characterised in that** said driver device has an associated voltage-to-current converter (44) for generating said at least one component of said modulation current as a function of the output of said comparator (34).

6. The system of claim 5, **characterised in that** it includes a multiplier block (42) arranged between said comparator (34) and said associated voltage-to-current converter (44) to provide said at least one gain factor.

7. The system of any of the previous claims, **characterised in that** said driver device (22) is programmable for selectively varying at least one of:
- said predetermined optical power set point signal (26),
- the model implemented in said modelling block (38) for generating said current threshold value (36) as a function of said second signal (14) indicative of said temperature sensed (T), and
- the value of said at least one gain factor (42) associated with said comparator (34) to produce said at least one component of said modulation current (10) as a function of said difference (40).

8. The system of any of the previous claims, **characterised in that** said driver device (22) is a programmable system on a chip ("psoc").

9. The system of any of the previous claims, **characterised in that** said a control circuit (20) for controlling said bias current (B) is at least partly implemented as a programmable system on a chip ("psoc")

10. The system of any of the previous claims, the system including :
- a source driver (60) configured for producing said modulation current (M) for said source (L) as a function of a first, near dc modulation component and a second, high speed, data modulation (62) component, said source driver (60) producing a gain between said first near dc modulation component and said modulation current (M) for said source (L), wherein said gain is exposed to variations,
- a driver device (22) configured for producing said first, near dc modulation component, and
- a feedback loop (64) from said modulation current (M) for said source (L) and said driver device (22) to stabilize said modulation current (M) for said source (L) against said variations.

11. The system of claim 10, **characterised in that** said feedback loop includes a RF power monitor (64) to sense said modulation current (M) for said source (L), provide a corresponding sensing signal, and feed said sensing signal back towards said driver device (22) configured for producing said first, near dc modulation component.

12. The system of claim 11, **characterised in that** said RF power monitor (64) provides a sensing signal proportional to said modulation current for said source (L) .

13. A method of controlling operation of an optical source (L) by controlling a bias current (B) and a modulation current (M) supplied (12, 10) thereto, wherein the method includes the step of sensing (16, T) the radiation generated by said optical source (L) and the temperature of said optical source (L) to derive a first signal (18) indicative of the power of said radiation and a second signal (14) indicative of said temperature, the method including the steps of:
- controlling (20) said bias current (B) as a function of the difference between said first signal (18) indicative of the power of said radiation and a predetermined optical power set point signal (26), while generating a signal (32) indicative of said bias current, and
- providing a driver device (22) configured for:
- producing (24) said predetermined optical power set point signal (26),
**characterised in that** the driver device is configured for:
- generating, based on a model (38), a current threshold value (36) as a function of said second signal (14) indicative of said temperature sensed (T),
- producing (34) the difference between said signal (32) indicative of said bias current (32) and said threshold current (36);
and further **characterised in that:**
the method includes the step of:
- producing via at least one gain factor (42, 60) at least one component of said modulation current (10) as a function (42) of said difference (40).

14. The method of claim 13, **characterised in that** it includes the step of selectively varying at least one of:
- said predetermined optical power set point signal (26),
- said model (38) used for generating said current threshold value (36) as a function of said second signal (14) indicative of said temperature sensed (T), and
- said at least one gain factor (42) used for producing said at least one component of said modulation current (10) as a function of said difference (40) .

15. The method of either of claims 13 or 14, **characterised in that** said step of generating based on a model (38) involves determining a value for said current threshold value (36) for each value of said second signal (14) indicative of said temperature sensed (T).

16. A computer program product loadable in the memory of at least one computer and including software code portions which cause said computer to perform the function of the driver device (22) of the system of any of claims 1 to 12.

17. A computer program product loadable in the memory of at least one computer and including software code portions for performing the steps of any of claims 13 to 15.

## Patentansprüche

1. System, geeignet zum Steuern des Betriebes einer optischen Quelle (L) durch Steuern eines Biasstromes (B) und eines Modulationsstromes (M), die in sie eingespeist (12, 10) werden, wobei die Quelle zugeordnete Sensoren (16, T) zum Detektieren der durch die optische Quelle (L) erzeugten Strahlung und der Temperatur der optischen Quelle (L) aufweist, um ein erstes Signal (18) zu erlangen, das die Leistung der Strahlung anzeigt, und ein zweites Signal (14) zu erlangen, das die Temperatur anzeigt, wobei das System aufweist:
- eine Steuerschaltung (20) zum Steuern des Biasstromes (B) als eine Funktion der Differenz zwischen dem ersten Signal (18), das die Leistung der Strahlung anzeigt, und einem Vorgabe-Optikleistung-Sollwert-Signal (26), während ein Signal (32) erzeugt wird, das den Biasstrom anzeigt, und
- eine Treibervorrichtung (22), die aufweist:
- einen Ausgang (24) zum Erzeugen des Vorgabe-Optikleistung-Sollwert-Signals (26),
**dadurch gekennzeichnet, dass** die Treibervorrichtung des Weiteren aufweist:
- einen Modellierungsblock (38) zum Erzeugen eines Stromschwellenwert (36) als eine Funktion des zweiten Signals (14), das die detektierte Temperatur (T) anzeigt, und
- einen Komparator (34), in den das Signal (32) eingespeist wird, das den Biasstrom und den Schwellenstromwert (36) anzeigt, um deren Differenz zu erzeugen; wobei dem Komparator (34) zumindest ein Verstärkungsfaktor (42, 60) zugeordnet ist, um zumindest eine Komponente des Modulationsstromes (10) als eine Funktion (42) der Differenz (40) zu erzeugen.

2. System nach Anspruch 1, **dadurch gekennzeichnet, dass** die optische Quelle (L) eine Halbleiterlaserquelle ist.

3. System nach Anspruch 1, **dadurch gekennzeichnet, dass** es einen analogen Schaltkreis (20) aufweist, um den Biasstrom (12) als eine Funktion des ersten Signals (18), das die Leistung der Strahlung anzeigt, und des Vorgabe-Optikleistung-SollwertSignals (26) zu erzeugen.

4. System nach Anspruch 3, **dadurch gekennzeichnet, dass** es einen Spannung-Strom-Wandler (30) enthält, um den Biasstrom (12) als eine Funktion des ersten Signals (18), das die Leistung der Strahlung anzeigt, und des Vorgabe-Optikleistung-SollwertSignals (26) zu erzeugen.

5. System nach einem der vorangehenden Ansprüche, **dadurch gekennzeichnet, dass** die Treibervorrichtung einen zugeordneten Spannung-Strom-Wandler (44) aufweist, um die zumindest eine Komponente des Modulationsstromes als eine Funktion des Ausgangs des Komparators (34) zu erzeugen.

6. System nach Anspruch 5, **dadurch gekennzeichnet, dass** es einen Multiplierblock (42) aufweist, der zwischen dem Komparator (34) und dem zugeordneten Spannung-Strom-Wandler (44) angeordnet ist, um zumindest einen Verstärkungsfaktor bereitzustellen.

7. System nach einem der vorangehenden Ansprüche, **dadurch gekennzeichnet, dass** die Treibervorrichtung (22) programmierbar ist, um selektiv zumindest eines der Folgenden zu ändern:
- das Vorgabe-Optikleistung-Sollwert-Signal (26),
- das in dem Modellierungsblock (38) implementierte Modell zum Erzeugen des Stromschwellenwertes (36) als eine Funktion des zweiten Signals (14), das die detektierte Temperatur (T) anzeigt, und
- den Wert des zumindest einen Verstärkungsfaktors (42), der dem Komparator (34) zugeordnet ist, um die zumindest eine Komponente des Modulationsstromes (10) als eine Funktion der Differenz (40) zu erzeugen.

8. System nach einem der vorangehenden Ansprüche, **dadurch gekennzeichnet, dass** die Treibervorrichtung (22) ein programmierbares System auf einem Chip ("psoc") ist.

9. System nach einem der vorangehenden Ansprüche, **dadurch gekennzeichnet, dass** die Steuerschaltung (20) zum Steuern des Biasstromes (B) zumindest teilweise als ein programmierbares System auf einem Chip("psoc") implementiert ist.

10. System nach einem der vorangehenden Ansprüche, wobei das System aufweist:
- einen Quellentreiber (60), der dafür konfiguriert ist, den Modulationsstrom (M) für die Quelle (L) als eine Funktion einer ersten, Nah-Gleichstrom-Modulation Komponente, und einer zweiten, Hochgeschwindigkeits, Datenmodulations (62) -Komponente, zu erzeugen, wobei der Quellentreiber (60) eine Verstärkung zwischen der ersten Nah-Gleichstrom-Modulation Komponente, und dem Modulationsstrom (M) für die Quelle (L) erzeugt, wobei die Verstärkung Änderungen ausgesetzt ist,
- eine Treibervorrichtung (22), die dafür konfiguriert ist, die erste, Nah-Gleichstrom-Modulation Komponente, zu erzeugen, und
- eine Rückkopplungsschleife (64) von dem Modulationsstrom (M) für die Quelle (L) und die Treibervorrichtung (22) zum Stabilisieren des Modulationsstromes (M) für die Quelle (L) gegen die Änderungen.

11. System nach Anspruch 10, **dadurch gekennzeichnet, dass** die Rückkopplungsschleife eine HF-Leistungs-Überwachungsvorrichtung (64) aufweist, um den Modulationsstrom (M) für die Quelle (L) zu detektieren, ein entsprechendes Detektionssignal bereitzustellen und das Detektionssignal zu der Treibervorrichtung (22) zurückzugeben, die dafür konfiguriert ist, die erste, Nah-Gleichstrom-Modulation Komponente, zu erzeugen.

12. System nach Anspruch 11, **dadurch gekennzeichnet, dass** die HF-Leistungs-Überwachungsvorrichtung (64) ein Detektionssignal ausgibt, das dem Modulationsstrom für die Quelle (L) proportional ist.

13. Verfahren zum Steuern des Betriebes einer optischen Quelle (L) durch Steuern eines Biasstromes (B) und eines Modulationsstromes (M), die in sie eingespeist (12, 10) werden, wobei das Verfahren den Schritt aufweist, die durch die optische Quelle (L) erzeugte Strahlung und die Temperatur der optischen Quelle (L) zu detektieren (16, T), um ein erstes Signal (18) zu erlangen, das die Leistung der Strahlung anzeigt, und ein zweites Signal (14) zu erlangen, das die Temperatur anzeigt, wobei das Verfahren die Schritte aufweist:
- Steuern (20) des Biasstromes (B) als eine Funktion der Differenz zwischen dem ersten Signal (18), das die Leistung der Strahlung anzeigt, und einem Vorgabe-Optikleistung-Sollwert-Signal (26), während ein Signal (32) erzeugt wird, das den Biasstrom anzeigt, und
- Bereitstellen einer Treibervorrichtung (22), die dafür konfiguriert ist:
- das Vorgabe-Optikleistung-Sollwert-Signal (26) zu erzeugen (24),
**dadurch gekennzeichnet, dass** die Treibervorrichtung dafür konfiguriert ist:
- auf der Grundlage eines Modells (38) einen Stromschwellenwert (36) als eine Funktion des zweiten Signals (14), das die detektierte Temperatur (T) anzeigt, zu erzeugen, und
- die Differenz zwischen dem Signal (32), das den Biasstrom (32) anzeigt, und dem Schwellenstrom (36) zu erzeugen (34);
und des Weiteren **dadurch gekennzeichnet, dass**:
das Verfahren den Schritt aufweist:
Erzeugen, über zumindest einen Verstärkungsfaktor (42, 60), zumindest einer Komponente des Modulationsstromes (10) als eine Funktion (42) der Differenz (40).

14. Verfahren nach Anspruch 13, **dadurch gekennzeichnet, dass** es den Schritt aufweist, selektiv zumindest eines der Folgenden zu ändern:
- das Vorgabe-Optikleistung-Sollwert-Signal (26),
- das Modell (38), das zum Erzeugen des Stromschwellenwertes (36) als eine Funktion des zweiten Signals (14) verwendet wird, das die detektierte Temperatur (T) anzeigt, und
- den zumindest einen Verstärkungsfaktor (42), der dafür verwendet wird, die zumindest eine Komponente des Modulationsstromes (10) als eine Funktion der Differenz (40) zu erzeugen.

15. Verfahren nach einem der Ansprüche 13 oder 14, **dadurch gekennzeichnet, dass** der Schritt des Erzeugens auf der Grundlage eines Modells (38) das Bestimmen eines Wertes für den Stromschwellenwert (36) für jeden Wert des zweiten Signals (14), das die detektierte Temperatur (T) anzeigt, aufweist.

16. Ein in den Speicher zumindest eines Computers ladbares Computerprogrammprodukt, das Softwarecodeabschnitte aufweist, die veranlassen, dass der Computer die Funktion der Treibervorrichtung (22) des Systems nach einem der Ansprüche 1 bis 12 ausführt.

17. Ein in den Speicher zumindest eines Computers ladbares Computerprogrammprodukt, das Softwarecodeabschnitte aufweist zum Ausführen der Schritte nach einem der Ansprüche 13 bis 15.

## Revendications

1. Système adapté pour commander le fonctionnement d'une source optique (L) en commandant un courant de polarisation (B) et un courant de modulation (M) qui lui sont fournis (12, 10), la source ayant des capteurs associés (16, T) pour détecter le rayonnement généré par ladite source optique (L) et la température de ladite source optique (L) pour dériver un premier signal (18) indicateur de la puissance dudit rayonnement et un deuxième signal (14) indicateur de ladite température, le système comprenant :
■ un circuit de commande (20) pour commander ledit courant de polarisation (B) en fonction de la différence entre ledit premier signal (18) indicateur de la puissance dudit rayonnement et un signal de consigne de puissance optique prédéterminée (26), tout en générant un signal (32) indicateur dudit courant de polarisation, et
■ un dispositif pilote (22) comprenant :
■ une sortie (24) pour produire ledit signal de consigne de puissance optique prédéterminée (26),
**caractérisé en ce que** le dispositif pilote comprend en outre :
■ un bloc de modélisation (38) pour générer une valeur de seuil de courant (36) en fonction dudit deuxième signal (14) indicateur de ladite température détectée (T), et
■ un comparateur (34) dans lequel sont alimentés ledit signal (32) indicateur dudit courant de polarisation et ladite valeur de courant de seuil (36) pour produire la différence entre ceux-ci, ledit comparateur (34) étant associé à au moins un facteur de gain (42, 60) pour produire au moins un composant dudit courant de modulation (10) en fonction (42) de ladite différence (40).

2. Système selon la revendication 1, **caractérisé en ce que** ladite source optique (L) est une source laser de semi-conducteurs.

3. Système selon la revendication 1, **caractérisé en ce qu'**il comprend un circuit analogique (20) pour produire ledit courant de polarisation (12) en fonction dudit premier signal (18) indicateur de la puissance dudit rayonnement et dudit signal de consigne de puissance optique prédéterminée (26).

4. Système selon la revendication 3, **caractérisé en ce qu'**il comprend un convertisseur de tension en intensité (30) pour générer ledit courant de polarisation (12) en fonction dudit premier signal (18) indicateur de la puissance dudit rayonnement et dudit signal de consigne de puissance optique prédéterminée (26).

5. Système selon l'une quelconque des revendications précédentes, **caractérisé en ce que** ledit dispositif pilote a un convertisseur de tension en intensité (44) associé pour générer ledit au moins un composant dudit courant de modulation en fonction de la sortie dudit comparateur (34).

6. Système selon la revendication 5, **caractérisé en ce qu'**il comprend un bloc multiplicateur (42) agencé entre ledit comparateur (34) et ledit convertisseur de tension en intensité (44) associé pour fournir ledit au moins un facteur de gain.

7. Système selon l'une quelconque des revendications précédentes, **caractérisé en ce que** ledit dispositif pilote (22) est programmable pour faire varier de manière sélective au moins l'un de :
■ ledit signal de consigne de puissance optique prédéterminée (26),
■ le modèle mis en oeuvre dans ledit bloc de modélisation (38) pour générer ladite valeur de seuil de courant (36) en fonction dudit deuxième signal (14) indicateur de ladite température détectée (T), et
■ la valeur dudit au moins un facteur de gain (42) associé audit comparateur (34) pour produire ledit au moins un composant dudit courant de modulation (10) en fonction de ladite différence (40).

8. Système selon l'une quelconque des revendications précédentes, **caractérisé en ce que** ledit dispositif pilote (22) est un système programmable sur une puce (« psoc »).

9. Système selon l'une quelconque des revendications précédentes, **caractérisé en ce que** ledit un circuit de commande (20) pour commander ledit courant de polarisation (B) est au moins partiellement mis en oeuvre en tant que système programmable sur une puce (« psoc »).

10. Système selon l'une quelconque des revendications précédentes, le système comprenant :
■ un pilote de source (60) configuré pour produire ledit courant de modulation (M) pour ladite source (L) en fonction d'un premier composant de modulation cc rapproché et d'un deuxième composant de modulation de données à grande vitesse (62), ledit pilote de source (60) produisant un gain entre ledit premier composant de modulation cc rapproché et ledit courant de modulation (M) pour ladite source (L), dans lequel ledit gain est exposé à des variations,
■ un dispositif pilote (22) configuré pour produire ledit premier composant de modulation cc rapproché, et
■ une boucle de retour (64) dudit courant de modulation (M) pour ladite source (L) et ledit dispositif pilote (22) pour stabiliser ledit courant de modulation (M) pour ladite source (L) par rapport auxdites variations.

11. Système selon la revendication 10, **caractérisé en ce que** ladite boucle de retour comprend un moniteur de puissance RF (64) pour détecter ledit courant de modulation (M) pour ladite source (L), fournir un signal de détection correspondant, et alimenter ledit signal de détection de retour vers ledit dispositif pilote (22) configuré pour produire ledit premier composant de modulation cc rapproché.

12. Système selon la revendication 11, **caractérisé en ce que** ledit moniteur de puissance RF (64) fournit un signal de détection proportionnel audit courant de modulation pour ladite source (L).

13. Procédé de commande du fonctionnement d'une source optique (L) en commandant un courant de polarisation (B) et un courant de modulation (M) qui lui sont fournis (12, 10), dans lequel le procédé comprend l'étape consistant à détecter (16, T) le rayonnement généré par ladite source optique (L) et la température de ladite source optique (L) pour dériver un premier signal (18) indicateur de la puissance dudit rayonnement et un deuxième signal (14) indicateur de ladite température, le procédé comprenant les étapes consistant à :
■ commander (20) ledit courant de polarisation (B) en fonction de la différence entre ledit premier signal (18) indicateur de la puissance dudit rayonnement et un signal de consigne de puissance optique prédéterminé (26), tout en générant un signal (32) indicateur dudit courant de polarisation, et
■ fournir un dispositif pilote (22) configuré pour :
■ produire (24) ledit signal de consigne de puissance optique prédéterminée (26),
**caractérisé en ce que** le dispositif pilote est configuré pour :
■ générer, sur la base d'un modèle (38), une valeur de seuil de courant (36) en fonction dudit deuxième signal (14) indicateur de ladite température détectée (T),
■ produire (34) la différence entre ledit signal (32) indicateur dudit courant de polarisation (32) et ledit courant de seuil (36) ;
et en outre **caractérisé en ce que** :
le procédé comprend l'étape consistant à :
■ produire par le biais d'au moins un facteur de gain (42, 60) au moins un composant dudit courant de modulation (10) en fonction (42) de ladite différence (40).

14. Procédé selon la revendication 13, **caractérisé en ce qu'**il comprend l'étape consistant à faire varier de manière sélective au moins l'un de :
■ ledit signal de consigne de puissance optique prédéterminée (26);
■ ledit modèle (38) utilisé pour générer ladite valeur de seuil de courant (36) en fonction dudit deuxième signal (14) indicateur de ladite température détectée (T), et
■ ledit au moins un facteur de gain (42) utilisé pour produire ledit au moins un composant dudit courant de modulation (10) en fonction de ladite différence (40).

15. Procédé selon la revendication 13 ou 14, **caractérisé en ce que** ladite étape de génération sur la base d'un modèle (38) implique la détermination d'une valeur pour ladite valeur de seuil de courant (36) pour chaque valeur dudit deuxième signal (14) indicateur de ladite température détectée (T).

16. Produit de programme d'ordinateur chargeable dans la mémoire d'au moins un ordinateur et comprenant des portions de code logiciel qui amènent ledit ordinateur à effectuer la fonction du dispositif pilote (22) du système de l'une quelconque des revendications 1 à 12.

17. Produit de programme d'ordinateur chargeable dans la mémoire d'au moins un ordinateur et comprenant des portions de code logiciel pour effectuer les étapes de l'une quelconque des revendications 13 à 15.
